# EUROPEAN PATENT SPECIFICATION

(11) **EP 0 383 326 B1**
(45) Date of publication and mention of the grant of the patent: **07.09.1994**
(21) Application number: 90102963.7
(22) Date of filing: 15.02.1990
(51) Int. Cl.: H03H 17/06

(54) **Fir digital filter for high-speed communications systems**
Digitaler Fir-Filter für Hochgeschwindigkeits-Kommunikationssysteme
Filtre numérique du type fir pour systèmes de communications à grande vitesse

(30) Priority: 16.02.1989 JP 37486/89
(43) Date of publication of application: 22.08.1990
(73) Proprietor: NEC CORPORATION, Tokyo (JP)
(72) Inventor: Eisaku, Sasaki, Minato-ku, Tokyo (JP)
(74) Representative: VOSSIUS & PARTNER

(56) References cited:
- EP-A- 0 180 989
- GB-A- 2 153 618
- PATENT ABSTRACTS OF JAPAN, vol. 11, no. 217 (E-523)[2664], 14th July 1987;& JP-A-62 36 912 (HITACHI) 17-02-1987

## Description

The present invention relates generally to digital filters, and more specifically to a high-speed digital filter suitable for digital radio transmission systems.

Due to the sharp cutoff capability and high cost performance, digital filters are increasingly used in many applications, instead of analog filters. Digital filters are of two types, i.e., IIR (infinite impulse response) filter and FIR (finite impulse response) filter. For digital radio, FIR low-pass filters are employed because of their linear operating characteristic for input-output phase relationship. Since the shift registers that comprise a digital filter are the primary source of aliasing, or fold-over distortion noise, they are clocked at twice the symbol rate for oversampling the incoming signal. The clock rate of the shift registers thus determines the maximum operating speed of a digital filter. If higher transmission speed is desired for a system, the clock rate of the digital filters must be increased. However, the operating speed of a digital filter is limited to the maximum operating speed of the integrated circuit components that comprise the shift registers and other constituent parts of the filter.

One approach would be to design a digital filter with two parallel subsystems each being operated respectively on two clock sequences each being out of phase by π radian with respect to the other. However, the hardware cost of the filter is twice as much as the current FIR digital filter.

An FIR filter for two data streams including a demultiplexes at the output is disclosed in the document EP-A-0 180 989.

It is therefore an object of the present invention to provide a finite impulse response digital filter which is capable of operating at higher speeds to meet the high speed requirement of digital communications systems without increasing hardware cost. This object is solved with the features of the claims.

The tap weights have symmetric values with respect to the center tap point value cₘ₊₁, and therefore, a relation cⱼ = c₂ₙ₊₂₋ⱼ holds.

The present invention will be described in further detail with reference to the accompanying drawings, in which:
Fig. I is a block diagram of a prior art digital filter;
Fig. 2 is a timing diagram associated with the prior art digital filter;
Fig. 3 is a block diagram of a digital filter according to a first embodiment of the present invention;
Fig. 4 is a timing diagram useful for describing the operation of the present invention; and
Fig. 5 is a block diagram of a second embodiment of this invention.

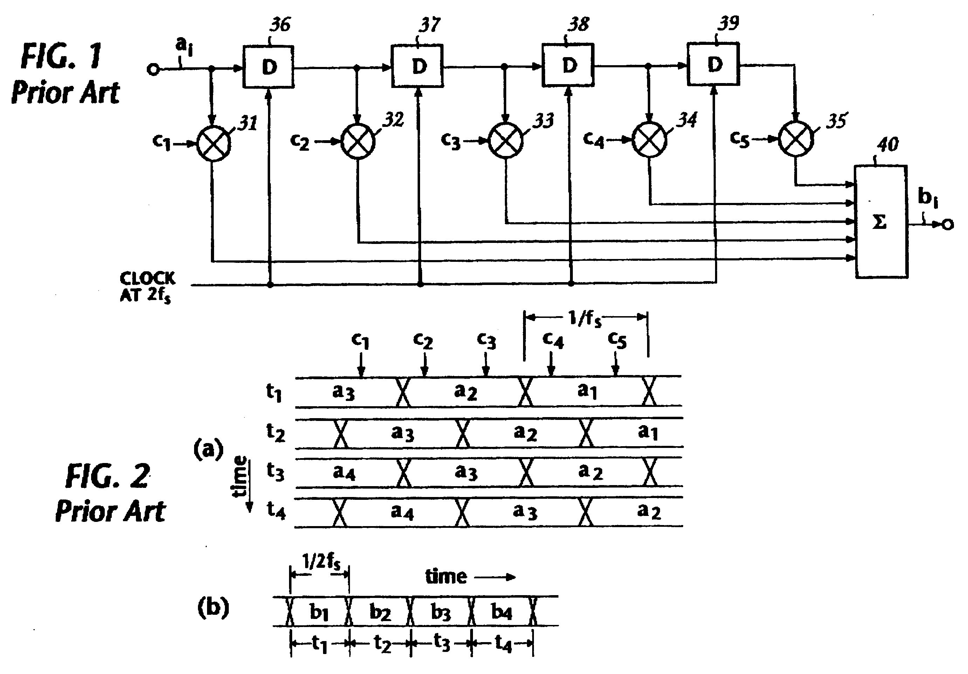

Before going into the details of the present invention, it is appropriate to describe a prior art FIR digital filter having an odd-number of tap weight coefficients. In Fig. 1, input digital samples with a symbol rate fₛ are supplied to the tapped delay line consisting of shift registers 36 to 39 defining successive tap points to which tap weight multipliers 31 to 35 are respectively connected. Shift registers 36 to 39 are clocked at twice the symbol rate fₛ to oversample the incoming signal. The successively delayed digital samples are multiplied with tap weight coefficients c₁ to c₅ respectively by the multipliers and summed altogether by an adder 40 to produce an output sequence bᵢ. The filter has a roll-off characteristic which is symmetric with respect to the center tap. Therefore, the relations c₁ = c₅ and c₂ = c₄ hold. Since shift registers 36-39 are driven at twice the speed of digital samples travelling through the tapped delay line, a digital sample a₁ appears at the inputs of multipliers 34 and 35 at a given instant t₁ as illustrated in part (a) of Fig. 2, and similarly a succeeding digital sample a₂ appears at the inputs of multipliers 32 and 33 and the next sample a₃ appears solely at the input of multiplier 31. The summation of these multiplied digital samples results in an output sample b₁ of duration 1/2fₛ as indicated in part (b) of Fig. 2. At time t₂ which is displaced by interval 1/2fₛ with respect to t₁, digital sample a₁ appears only at the input of multiplier 35, and digital sample a₂ appears at the inputs of multipliers 33 and 34 and digital sample a₃ appears at the inputs of multipliers 31 and 32, resulting in an output sample b₂. In like manner, at time t₃, digital samples a₂ and a₃ appear simultaneously at the inputs of multipliers 34, 35 and 33 and 32, with digital sample a₄ appearing solely at the input of multiplier 31, and at time t₄, samples a₃ and a₄ appear simultaneously at the inputs of multipliers 34, 33 and 32 and 31, with sample a₂ appearing solely at the input of multiplier 35.

Therefore, the output digital samples bᵢ can be represented as follows:
b₁ = (c₄ + c₅) a₁ + (c₂ + c₃) a₂ + c₁ × a₃
b₂ = c₅ × a₁ + (c₃ + c₄) a₂ + (c₁ + c₂) a₃
b₃ = (c₄ + c₅) a₂ + (c₂ + c₃) a₃ + c₁ × a₄
b₄ = c₅ × a₂ + (c₃ + c₄) a₃ + (c₁ + c₂) a₄
It is seen that like tap weight coefficients appear cyclically at sampling intervals 1/2fₛ. If the following is given:
d₁ = c₄ + c₅
d₂ = c₂ + c₃
d₃ = c₁
b₁ and b₃ can be represented as:
b₁ = d₁ × a₁ + d₂ × a₂ + d₃ × a₃
b₃ = d₁ × a₂ + d₂ × a₃ + d₃ × a₄
Since c₅ = c₁ and c₄ = c₂, d₁, d₂ and d₃ are also given by:
d₁ = c₁ + c₂
d₂ = c₃ + c₄
d₃ = c₅
Therefore, b₂ and b₄ can be represented as follows:
b₂ = d₃ × a₁ + d₂ × a₂ + d₁ × a₃
b₄ = d₃ × a₂ + d₂ × a₃ + d₁ × a₄

In general terms, dⱼ = cⱼ + cⱼ₊₁ = c₂ₙ₊₁₋ⱼ + c₂ₙ₊₂₋ⱼ, and the center tap coefficient dₘ₊₁ = c₁ = c₂ₙ₊₁, where j is in the range between 1 and 2n+1 for coefficients "c" and between 1 and 2m+1 for coefficients "d", and n ≧ 2 and m ≧ 1. Therefore, the odd-numbered output digital samples can be represented by dⱼ × aᵢ + dⱼ₊₁ × aᵢ₊₁ + ····· + d₂ₘ₊₁ × a₂ₘ₊₁ and the even-numbered output digital sample is represented by d₂ₘ₊₁ × aᵢ + d₂ₘ × aᵢ₊₁ + ····· + dⱼ₊₁ × a₂ₘ + dⱼ × a₂ₘ₊₁.

It follows from the foregoing that the output of the digital filter is divided into first and second groups. In the first group, output samples are sequentially multiplied by tap weights d₁, d₂ and d₃ according to their order of occurrence, while in the second group, output samples are sequentially multiplied by the tap weights in sequence which is opposite to the order of occurrence of the first group.

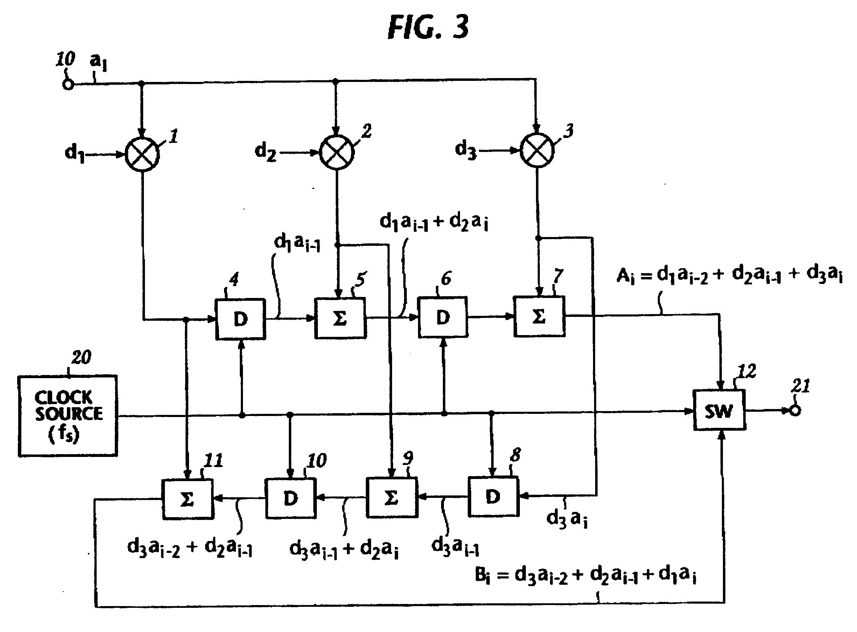

Referring now to Fig. 3, there is shown a FIR digital filter according to the present invention. The digital filter of the present invention has at least five virtual tap weights which are represented by at least three physical tap weights d₁, d₂ and d₃ just described, and is so constructed that it generates output samples b₁ and b₃ which appear in a first output sequence Aᵢ at alternate intervals with output samples b₂ and b₄ which appear in a second output sequence Bᵢ.

An input digital sample aᵢ at symbol rate fₛ is applied to an input terminal 10 to which are connected the input terminals of tap weight multipliers 1, 2 and 3 having tap weight coefficients d₁, d₂ and d₃, respectively. For generating the output sequences Aᵢ and Bᵢ, first and second delay-and-adder circuits are provided. The first delay-and-adder circuit comprises a shift register 4, an adder 5, a shift register 6 and an adder 7. The second delay-and-adder circuit comprises a shift register 8, an adder 9, a shift register 10 and an adder 11, all of which are connected in order opposite to that of the first delay-and-adder circuit. All shift registers 4, 6, 8 and 10 are clocked by a clock source 20 at intervals T=1/fₛ.

The output terminal of multiplier 1 is connected to the input of shift register 4 and to an input terminal of adder 11. Shift register 4 delays the input digital sample for a duration T equal to the reciprocal of the symbol rate fₛ and produces a digital output sample d₁ × aᵢ₋₁ which is supplied to an input of adder 5 to which the output of multiplier 2 is supplied. Therefore, adder 5 produces an output sample d₁ × aᵢ₋₁ + d₂ × aᵢ which is applied to and delayed for interval T by shift register 6 for introduction of a further delay, producing an output sample represented by d₁ × aᵢ₋₂ + d₂ × aᵢ₋₁. Adder 7 sums the output of shift register 6 with the output of multiplier 3, generating an output Aᵢ represented by a sum of samples d₁ × aᵢ₋₂ + d₂ × aᵢ₋₁ + d₃ × aᵢ at one input of a switch 12.

On the other hand, shift register 8 introduces a delay interval T to the output of multiplier 3 and applies a delayed output sample d₃ × aᵢ₋₁ to adder 9 which sums it with the output of multiplier 2, producing an output d₃ × aᵢ₋₁ + d₂ × a₁ at the input of shift register 10. Shift register 10 delays it for an additional interval T, presenting a delayed output sample d₃ × aᵢ₋₂ + d₂ × a₁₋₁ which is summed by adder 11 with the output of multiplier 1 to produce an output sequence Bᵢ represented by d₃ × aᵢ₋₂ + d₂ × aᵢ₋₁ + d₁ × aᵢ at the other input of switch 12.

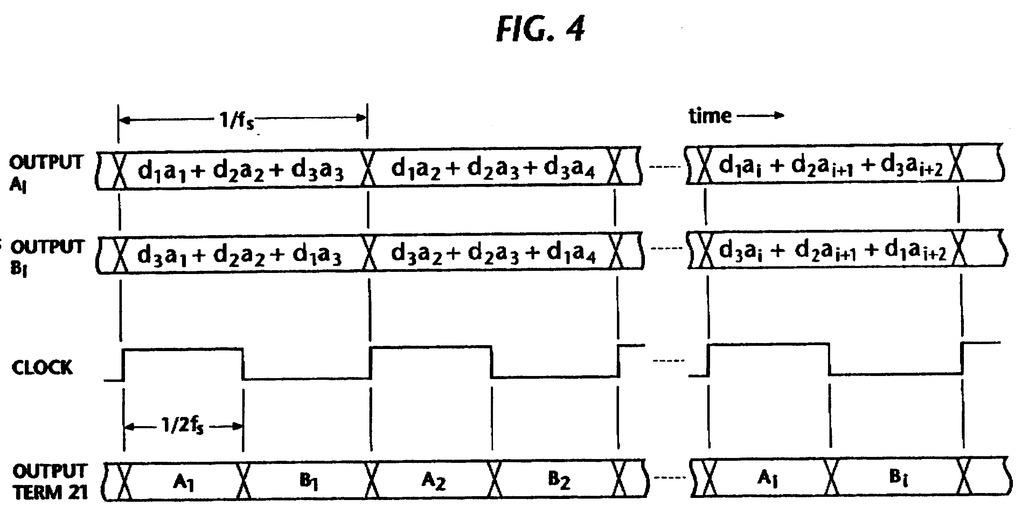

As illustrated in Fig. 4, during a first interval 1/fₛ the output sequence Aᵢ comprises a sum of d₁ × a₁, d₂ × a₂ and d₃ × a₃ and the output sequence Bᵢ comprises a sum of d₃ × a₁, d₂ × a₂ and d₁ × a₃. During a second interval 1/fₛ, the output sequence Aᵢ comprises a sum of d₁ × a₂, d₂ × a₃ and d₃ × a₄ and the sequence Bᵢ comprises a sum of d₃ × a₂, d₂ × a₃ and d₁ × a₄.

Switch 12 is a sampling means which is driven by the clock source 20 at intervals T=1/fₛ to sample the output sequence Aᵢ for a first half duration T/2 and sample the output sequence Bᵢ for a second half duration. The sampled half-duration signals are multiplexed at the output of switch 12 into a single stream and coupled to the filter output terminal 21. As a result, the sampling rate of the digital filter of the invention is one-half the sampling rate of the digital filter of the type as shown in Fig. 3. Since the symbol rate of the incoming signal is equal to the Nyquist rate, and each of the output sequences is sampled for duration 1/2fₛ, the incoming signal is double-oversampled. Therefore, the shift registers are no longer the source of aliasing noise and hence it is not necessary to operate them at twice the symbol rate. The present invention provides a digital filter which is simple in configuration and is capable of processing incoming signals having a symbol rate higher than fₛ.

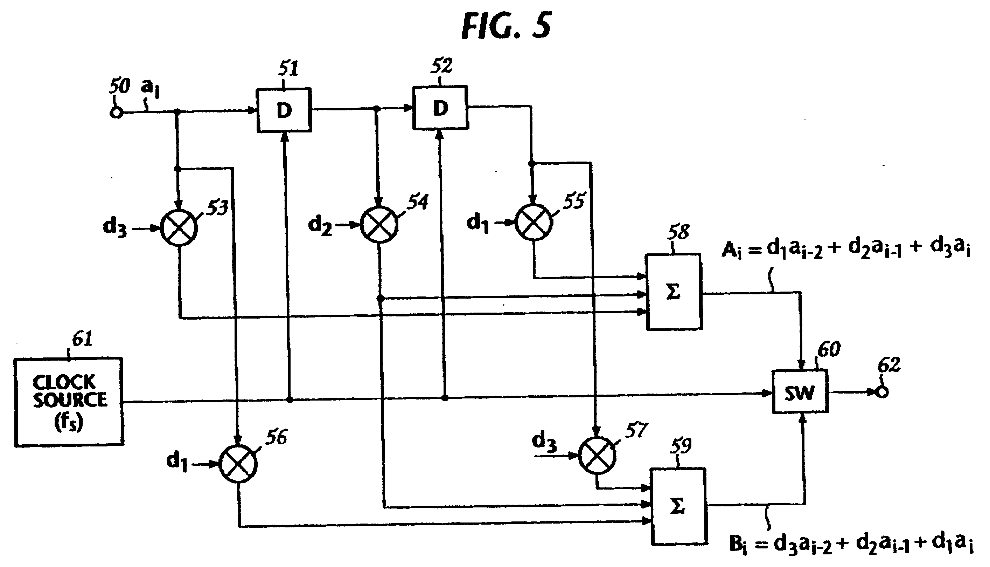

Fig. 5 is an illustration of a modified form of the digital filter of the invention. In this modification, shift registers 51 and 52 are connected in series from an input terminal 50 to define successive taps to which digital multipliers 53, 54 and 55 of a first set are connected, respectively, and digital multipliers 56 and 57 of a second set are connected to those taps to which multlpliers 53 and 55 are connected. Multipliers 53, 54 and 55 have tap weight coefficients d₃, d₂ and d₁, respectively, and multipliers 56 and 57 have coefficients d₁ and d₃, respectively. The outputs of multipliers 53-55 are connected to a first adder 58 to produce the output sequence Aᵢ and the outputs of multipliers 56, 54 and 57 are connected to a second adder 59 to produce the second output sequence Bᵢ. The output sequences are alternately sampled at intervals T=1/fₛ for half duration T/2 by a switch 60 in response to clock pulses from source 61 for oversampling the incoming signal at twice the symbol rate fₛ and multiplexed for application to an output terminal 62. Similar to the first embodiment, shift registers 51 and 52 are clocked at intervals T=1/fₛ by clock source 61 so that digital samples are delayed for unit interval T by each of the shift registers.

Successively arriving incoming digital samples at symbol rate fₛ are therefore delayed by shift registers 51 and 52, producing samples aᵢ, aᵢ₋₁ and aᵢ₋₂ which are multiplied respectively by multipliers 53-55, producing a weighted output sample d₃ × aᵢ from multiplier 53, a second output sample d₂ × aᵢ₋₁ from multiplier 54, and a third output sample d₁ × aᵢ₋₂ from multiplier 55. These weighted samples are summed by adder 58 into the output sequence Aᵢ = d₁ × aᵢ₋₂ + d₂ × aᵢ₋₁ + d₃ × aᵢ. Likewise, digital samples aᵢ and aᵢ₋₂ are further multiplied by multipliers 56 and 57, respectively, producing a first output sample d₁ × aᵢ from multiplier 56, a second output sample d₂ × aᵢ₋₁ from multiplier 54, and a third output sample d₃ × aᵢ₋₂ from multiplier 57. These weighted samples are summed by adder 59, resulting in the output sequence Bᵢ = d₃ × aᵢ₋₂ + d₂ × aᵢ₋₁ + d₁ × aᵢ.

## Claims

1. A finite impulse response digital filter for a digital communications system, the filter including (2n + 1) successive virtual taps respectively having tap weight coefficients cⱼ, where n is integer and equal to or greater than 2 and j is in the range between 1 and 2n+1, where cⱼ = c₂ₙ₊₂₋ⱼ, comprising:
add-and-delay multiplier circuit means having (2m + 1) physical taps having tap weight coefficients dⱼ, where m is integer and equal to or greater than unity and dⱼ = cⱼ + cⱼ₊₁ = c₂ₙ₊₁₋ⱼ + c₂ₙ₊₂₋ⱼ, and dₘ₊₁ = c₁ = c₂ₙ₊₁, said circuit means comprising a plurality of tap weight multipliers (1,2,3), and a plurality of delay elements (4,6,8,10) connected to said multipliers to define said physical taps, and a plurality of adders (5,7,9,11), the arrangement of said circuit means being such that a first digital output sequence Aᵢ comprising dⱼ × aᵢ + dⱼ₊₁ × aᵢ₊₁ + ····· + d₂ₘ₊₁ × a₂ₘ₊₁ appears at the output of one of said adders (7) and a second digital output sequence Bᵢ comprising d₂ₘ₊₁ × aᵢ + d₂ₘ × aᵢ₊₁ + ····· + dⱼ₊₁ × a₂ₘ + dⱼ × a₂ₘ₊₁ appears at the output of another of said adders (11), where aᵢ represents a digital sample at a given instant, and aᵢ₊₁ represents a digital sample displaced by an interval T with respect to said digital sample aᵢ, where T is the reciprocal of the symbol rate of digital samples of said communications system; and
means for sampling (12) said first output sequence at intervals T for a first half duration and sampling said second output sequence at intervals T for a second half duration and multiplexing the sampled sequences into a single sequence for coupling to an output terminal (21) of said digital filter.

2. A finite impulse response digital filter as claimed in claim 1, wherein each of said delay elements (4,6,8,10) is a shift register clocked at intervals T.

3. A finite impulse response digital filter as claimed in claim 1 or 2, wherein said add-and-delay multiplier circuit means comprises:
a plurality of tap weight multipliers (1,2,3) connected to an input terminal (10) of said digital filter to form successive physical taps for multiplying an input digital sample with said physical tap weight coefficients d₁, d₂ .... dₖ and dₖ₊₁ to produce weighted output digital samples (d₁, d₂ .... dₖ and dₖ₊₁) × aᵢ;
a first delay-and-adder circuit including a series of alternately series-connected delaying and summing elements, each of said delaying elements (4,6) delaying each of the weighted output digital samples for interval T to produce successively delayed samples, and each of said summing elements (5,7) summing the outputs of said multipliers and said delaying elements to produce a first group of output digital samples d₁ × aᵢ₋ₖ, d₂ × aᵢ₋₍ₖ₋₁₎, ..... dₖ × aᵢ₋₁ and dₖ₊₁ × aᵢ as said first output sequence; and
a second delay-and-adder circuit including a series of alternately series-connected delaying and summing elements, each of said delaying elements (8,10) delaying each of the weighted output digital samples for interval T to produce successively delayed samples, and each of the last-mentioned summing elements (9,11) summing the outputs of said multipliers and the last-mentioned delaying elements to produce a second group of output digital samples dₖ₊₁ × aᵢ₋ₖ, dₖ × aᵢ₍ₖ₋₁₎, ..... d₂ × aᵢ₋₁ and d₁ × aᵢ as said second output sequence.

4. A finite impulse response digital filter as claimed in claim 2 or 3, wherein each of the first, second, third and fourth delay means (4,6,8,10) comprises a shift register which is clocked at intervals T.

5. A finite impulse response digital filter as claimed in any one of claims 1 to 4, wherein said add-and-delay multiplier circuit means comprises:
delay elements (51,52) successively connected to an input terminal (50) of said filter to define successive physical taps for delaying each of successively arriving incoming digital samples for interval T;
a plurality of tap weight multipliers (53-57) connected respectively to said successive physical taps for multiplying successively delayed digital samples aᵢ₋ₖ, aᵢ₋₍ₖ₋₁₎,..... aᵢ₋₁ and aᵢ with said physical tap weight coefficients d₁, d₂ ..... dₖ and dₖ₊₁, respectively, to produce a first group of weighted output digital samples, and for multiplying digital samples aᵢ₋ₖ, aᵢ₋₍ₖ₋₁₎,..... aᵢ₋₁ and aᵢ with said physical tap weight coefficients dₖ₊₁, dₖ ..... d₂ and d₁, respectively, to produce a second group of weighted output digital samples; and
a first adder (58) for summing the weighted output digital samples of firtst group to produce said first output sequence; and
a second adder (59) for summing the weighted output digital samples of said second group to produce said second output sequence.

6. A finite impulse response digital filter as claimed in claim 5, wherein each of said delay means (51,52) comprises a shift register which is clocked at intervals T.

## Patentansprüche

1. Nichtrekursives (FIR-) Digitalfilter für ein digitales Kommunikationssystem, wobei das Filter (2n+1) aufeinanderfolgende virtuelle Anzapfungen, jeweils mit Wichtungskoeffizienten cⱼ, aufweist, wobei n eine ganze Zahl und mindestens gleich 2 ist und j im Bereich zwischen 1 und 2n + 1 liegt, mit cⱼ = c₂ₙ₊₂₋ⱼ, welches Filter aufweist:
eine Addier- und Verzögerungs-Multiplizierschaltung, die (2m + 1) physikalische Anzapfungen mit Anzapfungs-Wichtungskoeffizienten dⱼ aufweist, wobei m eine ganze Zahl und mindestens gleich eins, dⱼ = cⱼ + cⱼ₊₁ = c₂ₙ₊₁₋ⱼ + c₂ₙ₊₂₋ⱼ und dₘ₊₁ = c₁ = c₂ₙ₊₁ ist, wobei die Schaltung mehrere Anzapfungs-Wichtungsmultiplizierglieder (1, 2, 3) und mehrere mit den Multipliziergliedern verbundene Verzögerungsglieder (4, 6, 8, 10), um die physikalischen Anzapfungen zu definieren, sowie mehrere Addierglieder (5, 7, 9, 11) aufweist, wobei die Schaltung so eingerichtet ist, daß eine erste digitale Ausgangssequenz Aᵢ mit dⱼ x aᵢ + dⱼ₊₁ x aᵢ₊₁ + ... + d₂ₘ₊₁ x a₂ₘ₊₁ am Ausgang eines der Addierglieder (7) und eine zweite digitale Ausgangssequenz Bᵢ mit d₂ₘ₊₁ x aᵢ + d₂ₘ aᵢ₊₁ + ... + dⱼ₊₁ x a₂ₘ + dⱼ x a₂ₘ₊₁ am Ausgang eines anderen Addiergliedes (11) anliegen, wobei aᵢ einen digitalen Abtastwert zu einem gegebenen Zeitpunkt und aᵢ₊₁ einen digitalen Abtastwert darstellt, der gegenüber dem digitalen Abtastwert aᵢ um ein Intervall T verschoben ist, wobei T der reziproke Wert der Symbolrate von digitalen Abtastwerten des Kommunikationssystems ist; und
eine Abtasteinrichtung (12), um in Intervallen T während einer ersten halben Abtastperiode die erste Ausgangssequenz und in Intervallen von T während einer zweiten halben Abtastperiode die zweite Ausgangssequenz abzutasten und die abgetasteten Sequenzen zu einer einzigen Sequenz zu multiplexieren und diese an einen Ausgangsanschluß (21) des Digitalfilters anzukoppeln.

2. FIR-Digitalfilter nach Anspruch 1, wobei jedes der Verzögerungsglieder (4, 6, 8, 10) ein in Intervallen T getaktetes Schieberegister ist.

3. FIR-Digitalfilter nach Anspruch 1 oder 2, wobei die Addier- und Verzögerungs-Multiplizierschaltung aufweist:
mehrere Anzapfungs-Wichtungsmultiplizierglieder (1, 2, 3), die mit einem Eingangsanschluß (10) des Digitalfilters verbunden sind, um aufeinanderfolgende physikalische Anzapfungen für die Multiplikation eines digitalen Eingangs-Abtastwertes mit den Wichtungskoeffizienten d₁, d₂ ... dₖ und dₖ₊₁ der physikalischen Anzapfungen zu bilden und gewichtete digitale Ausgangs-Abtastwerte (d₁, d₂ ... dₖ und dₖ₊₁) x aᵢ zu erzeugen;
eine erste Verzögerungs- und Addierschaltung mit einer Reihe von abwechselnd in Serie geschalteten Verzögerungs- und Addiergliedern, wobei jedes der Verzögerungsglieder (4, 6) jeden der gewichteten digitalen Ausgangs-Abtastwerte um ein Intervall T verzögert, um stufenweise verzögerte Abtastwerte zu erzeugen, und wobei jedes der Addierglieder (5, 7) die Ausgangssignale der Multiplizierglieder und der Verzögerungsglieder addiert, um eine erste Gruppe von digitalen Ausgangs-Abtastwerten d₁ x aᵢ₋ₖ, d₂ x aᵢ₋₍ₖ₋₁₎, ..., dₖ x aᵢ₋₁ und dₖ₊₁ x aᵢ als erste Ausgangssequenz zu erzeugen; und
eine zweite Verzögerungs- und Addierschaltung mit einer Reihe von abwechselnd in Serie geschalteten Verzögerungs- und Addiergliedern, wobei jedes der Verzögerungsglieder (8, 10) jeden der gewichteten digitalen Ausgangs-Abtastwerte um ein Intervall T verzögert, um stufenweise verzögerte Abtastwerte zu erzeugen, und wobei jedes der letztgenannten Addierglieder (9, 11) die Ausgangssignale der Multiplizierglieder und der letztgenannten Verzögerungsglieder addiert, um eine zweite Gruppe von digitalen Ausgangs-Abtastwerten dₖ₊₁ x aᵢ₋ₖ, dₖ x aᵢ₋₍ₖ₋₁₎, ..., d₂ x aᵢ₋₁ und d₁ x aᵢ als zweite Ausgangssequenz zu erzeugen.

4. FIR-Digitalfilter nach Anspruch 2 oder 3, wobei jedes der ersten, zweiten, dritten und vierten Verzögerungsglieder (4, 6, 8, 10) ein in Intervallen T getaktetes Schieberegister aufweist.

5. FIR-Digitalfilter nach einem der Ansprüche 1 bis 4, wobei die Addier- und Verzögerungs-Multiplizierschaltung aufweist:
Verzögerungsglieder (51, 52), die der Reihe nach mit einem Eingangsanschluß (50) des Filters verbunden sind, um aufeinanderfolgende physikalische Anzapfungen für die Verzögerung jedes der nacheinander ankommenden digitalen Abtastwerte um ein Intervall T zu definieren;
mehrere Anzapfungs-Wichtungsmultiplizierglieder (53-57), die mit je einer der aufeinanderfolgenden physikalischen Anzapfungen verbunden sind, um stufenweise verzögerte digitale Abtastwerte aᵢ₋ₖ, aᵢ₋₍ₖ₋₁₎, ..., aᵢ₋₁ bzw. aᵢ mit den Wichtungskoeffizienten d₁, d₂, ..., dₖ bzw. dₖ₊₁ der physikalischen Anzapfungen zu multiplizieren und eine erste Gruppe von gewichteten digitalen Ausgangs-Abtastwerten zu erzeugen, und um digitale Abtastwerte aᵢ₋ₖ, aᵢ₋₍ₖ₋₁₎, ..., aᵢ₋₁ bzw. aᵢ mit den Wichtungskoeffizienten dₖ₊₁, dₖ, ..., d₂ bzw. d₁ der physikalischen Anzapfungen zu multiplizieren und eine zweite Gruppe von gewichteten digitalen Ausgangs-Abtastwerten zu erzeugen; und
ein erstes Addierglied (58), um die gewichteten digitalen Ausgangs-Abtastwerte der ersten Gruppe zu addieren und eine erste Ausgangssequenz zu erzeugen; und
ein zweites Addierglied (59), um die gewichteten digitalen Ausgangs-Abtastwerte der zweiten Gruppe zu addieren und eine zweite Ausgangssequenz zu erzeugen.

6. FIR-Digitalfilter nach Anspruch 5, wobei jedes der Verzögerungsglieder (51, 52) ein in Intervallen T getaktetes Schieberegister aufweist.

## Revendications

1. Filtre numérique à réponse impulsionnelle finie pour un système de communication numérique, le filtre comportant (2n + 1) prises virtuelles successives ayant respectivement des coefficients de poids de prise cⱼ, où n est un nombre entier égal ou supérieur 2 et j se trouve dans la plage située entre 1 et 2n + 1, où cⱼ = c₂ₙ₊₂₋ⱼ, comprenant :
un moyen de circuit multiplicateur additionneur et à retard ayant (2n + 1) prises physiques ayant des coefficients de poids de prise dⱼ, où m est un nombre entier égal ou supérieur à l'unité et
dⱼ = cⱼ + cⱼ₊₁ = c₂ₙ₊₁₋ⱼ + c₂ₙ₊₂₋ⱼ et dₘ₊₁ = c₁ = c₂ₙ₊₁, ledit moyen de circuit comprenant une multitude de multiplicateurs de poids de prise (1, 2, 3) et une multitude d'éléments à retard (4, 6, 8, 10) connectés audit multiplicateur afin de définir lesdites prises physiques et une multitude d'additionneurs (5, 7, 9, 11), la disposition dudit moyen du circuit étant telle qu'une première séquence de sortie numérique Aᵢ comprenant
dⱼ X aᵢ + dⱼ₊₁ X aᵢ₊₁ + ...... + d₂ₘ₊₁ X a₂ₘ₊₁ apparaît à la sortie d'un desdits additionneurs (7) et une seconde séquence de sortie numérique Bᵢ comprenant
d₂ₘ₊₁ X aᵢ + d₂ₘ X aᵢ₊₁ + .... + dⱼ₊₁ X a₂ₘ + dⱼ X a₂ₘ₊₁ apparaît à la sortie d'un autre desdits additionneurs (11), où aᵢ représente un échantillon numérique à un instant donné et aᵢ₊₁ représente un échantillon numérique décalé d'un intervalle T par rapport audit échantillon numérique aᵢ, où T est la réciproque de la vitesse de symbole des échantillons numériques dudit système de communication, et
un moyen pour échantillonner (12) ladite première séquence de sortie à des intervalles T pendant une première demie durée et pour échantillonner ladite seconde séquence de sortie à des intervalles T pendant une seconde demie durée et pour multiplexer les séquences échantillonnées en une seule séquence pour couplage à une borne de sortie (21) dudit filtre numérique.

2. Filtre numérique à réponse impulsionnelle finie selon la revendication 1, dans lequel chacun desdits éléments à retard (4, 6, 8, 10) est un registre à décalage cadencé par horloge à des intervalles T.

3. Filtre numérique à réponse impulsionnelle finie selon la revendication 1 ou 2, dans lequel ledit moyen de circuit multiplicateur additionneur et à retard comprend :
une multitude de multiplicateurs de poids de prise (1, 2, 3) connectés à une porte(10)dudit filtre numérique afin de former des prises physiques successives pour multiplier un échantillon numérique d'entrée avec lesdits coefficients de poids de prise physique d₁, d₂ ... dₖ et dₖ₊₁ afin de produire des échantillons numériques de sortie pondérés (d₁, d₂... dₖ et dₖ₊₁) X aᵢ,
un premier circuit à retard et additionneur comportant une série d'éléments de retard et de sommation connectés en série alternée, chacun desdits éléments à retard (4, 6) retardant chacun des échantillons numériques de sortie pondérés pendant un intervalle T afin de produire des échantillons successivement retardés et chacun desdits éléments de sommation (5, 7) sommant les sorties desdits multiplicateurs et desdits éléments à retard afin de produire un premier groupe d'échantillons numériques de sortie d₁ X aᵢ₋ₖ, d₂ X aᵢ₋₍ₖ₋₁₎, ...dₖ X aᵢ₋₁ et dₖ₊₁ X aᵢ en tant que ladite première séquence de sortie, et
un second circuit à retard et additionneur comportant une série d'éléments de retard et de sommation connectés en série alternée, chacun desdits éléments à retard (8, 10) retardant chacun des échantillons numériques de sortie pondérés pendant un intervalle T afin de produire des échantillons successivement retardés et chacun desdits éléments de sommation mentionnés en dernier (9, 11) sommant les sorties desdits multiplicateurs et desdits éléments à retard mentionnés en dernier afin de produire un second groupe d'échantillons numériques de sortie
dₖ₊₁ X aᵢ₋ₖ, dₖ X aᵢ₋₍ₖ₋₁₎, ...d₂ X aᵢ₋₁ et d₁ X aᵢ en tant que ladite seconde séquence de sortie.

4. Filtre numérique à réponse impulsionnelle finie selon la revendication 2 ou 3, dans lequel chacun desdits premier, second, troisième et quatrième moyens de retard (4, 6, 8, 10) comprend un registre à décalage qui est cadencé par horloge à des intervalles T.

5. Filtre numérique à réponse impulsionnelle finie selon l'une quelconque des revendications 1 à 4, dans lequel ledit moyen de circuit multiplicateur, additionneur et de retard comprend :
des éléments à retard (51, 52) connectés successivement à une borne d'entrée (50) dudit filtre afin de définir des prises successives physiques pour retarder chacun des échantillons numériques entrant arrivant successivement pendant un intervalle T,
une multitude de multiplicateurs de poids de prise (53 à 57) connectés respectivement auxdites prises physiques successives pour multiplier les échantillons numériques successivement retardés aᵢ₋ₖ, aᵢ₋₍ₖ₋₁₎, ... aᵢ₋₁ et aᵢ avec les coefficients de poids de prise physique d₁, d₂ ... dₖ et dₖ₊₁, respectivement, afin de produire un premier groupe d'échantillons numériques de sortie pondérés et pour multiplier les échantillons numériques
aᵢ₋ₖ, aᵢ₋₍ₖ₋₁₎, ... aᵢ₋₁ et aᵢ avec les coefficients de poids de prise physique dₖ₋₁, dₖ... d₂ et d₁
respectivement, afin de produire un second groupe d'échantillons numériques de sortie pondérés, et
un premier additionneur (58) pour sommer les échantillons numériques de sortie pondérés dudit premier groupe afin de produire ladite première séquence de sortie et
un second additionneur (59) pour sommer les échantillons numériques de sortie pondérés dudit second groupe afin de produire ladite seconde séquence de sortie.

6. Filtre numérique à réponse impulsionnelle finie selon la revendication 5, dans lequel chacun desdits moyens de retard (51, 52) comprend un registre à décalage qui est cadencé par horloge à des intervalles T.
